# EUROPEAN PATENT APPLICATION

(11) **EP 1 033 744 A2**
(43) Date of publication of application: **06.09.2000**
(21) Application number: 00301505.4
(22) Date of filing: 25.02.2000
(51) Int. Cl.: H01L 21/027, H01L 21/268, H01L 21/3105, G03F 7/004, H01L 21/312, G03F 7/075

(54) **Improved dry photolithography process for deep ultraviolet exposure**

(30) Priority: 26.02.1999 US 121837 P; 18.02.2000 US 507173
(71) Applicant: Applied Materials, Inc., Santa Clara, California 95054 (US)
(72) Inventor: Weidman, Timothy, Sunnyvale, CA 94086 (US); Nault, Michael P., San Jose, CA 95120 (US); Bekiaris, Nikolaos, San Jose, California 95129 (US); Sugiarto, Dian, Union City, CA 94587 (US); Mui, David, San Jose, CA 95131 (US)
(74) Representative: Allard, Susan Joyce

(57) **Abstract**

An organosilane precursor having a silicon atom bound to at least two carbon atoms and to at least one hydrogen atom is used to form a deep ultra-violet photoresist layer with good edge definition and high contrast that is usable to define features with high resolution. The contrast of the photoresist layer can be selected according to the oxygen content in the development plasma. The plasma-polymerized organosilane layer is stable in air, both before and after photolithographic exposure for times consistent with conventional photolithographic processing of wafers in a production environment.

## Description

### CROSS-REFERENCES TO RELATED APPLICATIONS

This application is a continuation-in-part of U.S. Application No. 09/196,501, entitled DRY PHOTOLITHOGRAPHY FOR DEEP ULTRAVIOLET, by Dian Sugiarto and David Mui (Attorney Docket No. AM3237/T29100), filed November 19, 1998 and claims priority from U.S. Provisional Application Serial No. 60/121,837, entitled IMPROVED DRY PHOTOLITHOGRAPHY PROCESS FOR DEEP ULTRAVIOLET EXPOSURE, by Timothy Weidman, Michael Nault, Nikolaos Bekiaris, Dian Sugiarto and David Mui (Attorney Docket No. AM3504/T30200), filed February 26, 1999. The disclosures of 09/196,501 and 60/121,837 are incorporated herein by reference.

The present invention relates generally to photolithographic semiconductor processing techniques and more particular to a method and apparatus for depositing and developing a photoresist film.

The patterning of various deposited layers using photolithography techniques are common steps in the formation of today's integrated circuits and electronic devices. A variety of photolithographic processes have been developed. Many common photolithographic processes use a spin-on resist layer. The liquid resist material is applied to a wafer, and then the wafer is spun in a controlled fashion to leave a thin coating of the resist material on the wafer. The spin-on resist material is a light-sensitive material and is therefore referred to as photoresist. After spinning, and possibly other processes, such as soft baking, the layer of photoresist is exposed to light through a photomask (also known simply as a mask) that has transparent and opaque regions of a desired pattern. When the mask is exposed to light , e.g., ultraviolet ("UV") light, the transparent portions expose the photoresist in those regions, but not in the regions where the mask is opaque. The light causes a chemical reaction in exposed portions of the photoresist. A suitable chemical solution, chemical vapor, or plasma process is then used to selectively attack (etch away) either the reacted or unreacted portions of the photoresist, depending on the type of photoresist process, i.e. positive or negative, being used. This process of removing a selected portion of the photoresist layer to leave a patterned photoresist layer on the substrate is known as "developing". The remaining photoresist acts as a pattern for further processing of the underlying layer. For example, material may be deposited over the photoresist, which is then lifted off, or the underlying layer may be etched or otherwise processed. Processing the substrate according to the patterned photoresist layer is known as "pattern transfer".

Spin-on resist layers have limitations that make such them undesirable or unsuitable for some applications. In particular, as the critical dimension ("CD") of the devices being fabricated shrinks, new processes and techniques are used to attain smaller feature sizes. For example, a spin-on photoresist layer thick enough to withstand plasma treatments commonly used in the pattern-transfer process may be too thick to be properly exposed using the wavelengths necessary to obtain the desired CD. Photoresist materials that are adequately exposed (converted) at the longer wavelengths used in conventional photolithography processes might not be properly exposed by the shorter wavelength, deep ultra violet ("DUV"), light that is planned for deep-submicron photolithography. Many conventional photoresist materials absorb light in the DUV region, blocking the light from exposing the lower portions of the resist layer. Additionally, if a single, thin organic photoresist layer is spun onto a substrate, pinhole defects may form, and puddling and surface tension in the liquid resists limit their ability to conform to the topography of the substrate, becoming thicker or thinner is certain areas, and thus affecting exposure and development processes.

Alternative approaches to all-organic, single-layer resists have been developed. One approach, known as silyation, requires a special photoresist and is a relatively complicated and lengthy process. A second approach, which is an example of a bi-level approach, is to spin on a relatively thick layer of conventional photoresist or other polymer, and then to spin on a relatively thin layer of special photoresist that posses a high silicon content. The thin layer of resist is exposed and developed, and then processed to form a silicon-rich cap on the thicker layer. The upper layer is relatively rich in inorganic material and more resistant to some plasma etch processes, which can be used to transfer the pattern of the cap layer to the thicker underlayer. Conventional processing techniques may then be used to transfer the pattern of the multi-layer resist to the substrate.

Another alternative approach to liquid, organic, spin-on resists uses chemical vapor deposition ("CVD") techniques to deposit a layer of photosensitive material on a substrate. In particular, methylsilane ((CH₃)SiH₃) polymerizes in a plasma to form plasma-polymerized methylsilane ("PPMS"), which is photosensitive to light in the DUV region. PPMS deposition techniques are described in an article by Weidman et al., entitled "New Photodefinable Glass Etch Masks for Entirely Dry Photolithography: Plasma Deposited Organosilicon Hydride Polymers," published in Applied Physics Letters, vol. 62, no. 4, January 25, 1993, pgs. 372-374; U.S. Patent No. 5,439,780 to Joshi et al.; and an article by Weidman et al. entitled "All Dry Lithography: Applications of Plasma Polymerized Methylsilane as a Single Layer Resist and Silicon Dioxide Precursor," published in Journal of Photopolymer Science and Technology, vol. 8, no. 4, (1995), pp. 679-686.

As described in these references, a PPMS film having an organosilicon hydride network structure is deposited by plasma polymerization of a precursor gas containing methylsilane. When the PPMS film is exposed to DUV radiation in the presence of an oxidant such as ambient air, exposed portions of the PPMS film undergo photo-oxidation to form a glass-like, siloxane network material known as plasma-polymerized methylsilicon oxide (PPMSO). The resulting patterns can be developed to provide either negative tone or positive tone patterns. Negative tone patterns are generally formed using a chlorine-based plasma etch. Positive tone patterns can be formed using an HF vapor or buffered oxide etch. In either case, the developed pattern may optionally be further oxidized and annealed to convert the remaining material to an oxide hard mask. Such PPMS photolithography techniques are advantageous in that the deposition, development, patterning, and etching steps may all be performed in the gas phase, i.e., using dry plasma processing techniques and providing very high resolution.

PPMS layers thus find uses in a number of different photolithography applications. PPMS layers can suffer from some shortcomings, however. For example, PPMS layers typically oxidize in air, both prior to and after exposure. Such oxidation can lead to stability problems and can adversely affect the exposure and development processes. Some prior processes, traded off the photosensitivity of a PPMS layer against a more stable film. Additionally, PPMS layers present difficulties in working with lithography tools having wavelengths of 193 nm and less. Specifically, PPMS layers may absorb light too strongly at this wavelength.

It has been suggested to use precursor sources other than methylsilane in the formation of plasma-polymerized organosilane layers. For example, the Joshi '780 patent previously referred to experiments with dimethlysilane and tetramethylsilane. There is no indication within Joshi '780, however, that these or other organosilane sources provide benefits beyond those provided by methylsilane. Furthermore, the experiments in Joshi '780 indicate that precursors other than methylsilane absorbed light less efficiently suggesting that higher exposure doses would be required to pattern and develop the films. Work was also done at Lincoln Laboratory studying tetramethlysilane as a precursor for plasma-polymerized organosilane layers for 193 nm photolithography, but the exposure doses reported were far higher than what is practical for commercial applications. The Lincoln Laboratory deposition technique is described in Horn et al., "Plasma-deposited organosilicon thin films as dry resists for deep ultraviolet lithography," published in Journal of Vacuum Science and Technology, B8(6), November/December 1990, pp. 1493-1496.

In view of the above, improvements in photolithography techniques are desirable.

The present invention provides a new and improved dry photolithography technique that is particularly useful in the formation of integrated circuits having feature sizes of 0.18 microns or less. The invention deposits a stable plasma-polymerized organosilane (PPOS) layer from an organosilane precursor having at least two carbon atoms and at least one hydrogen atom bound to a silicon atom. The present inventors have discovered that plasma-polymerized organosilane films deposited from such precursors have improved stability as compared to organosilane precursors having only a single Si-C bond (e.g., PPMS) and have better absorbtion characteristics than films deposited from an organosilane precursor without any Si-H bonds. The plasma-polymerized organosilane layers formed according to the present invention are stable in air, both before and after photolithographic exposure for times consistent with conventional photolithographic processing of wafers in a production environment. Currently preferred embodiments of the present invention use dimethylsilane (DMS) and trimethylsilane (TMS) as precursor gases to deposit plasma-polymerized dimethylsilane (PPDMS) layers and plasma-polymerized trimethylsilane (PPTMS) layers, respectively.

Plasma polymerized layers deposited according to the present invention can be used to define submicron features after exposure to light. Typically, the plasma-polymerized organosilane layer is oxidized by exposing the layer to deep ultra-violet radiation in an oxygen-containing ambient, such as air. Radiation at 193 nm and 248 nm are particular examples of deep ultra-violet radiation suitable for exposing the layer. The exposed layer can be developed in a plasma containing a halogen and oxygen to define features having a resolution of less than or equal to 0.1 µm. The contrast between the exposed and unexposed layers is selectively controlled according to the oxygen content of the development plasma, and can vary between 1:1 and 1:1000, depending on the development etch parameters.

The present inventors also discovered quite unexpectedly that films formed from organosilane precursors having at least two carbon atoms and at least one hydrogen atom bound to a silicon atom can be successfully patterned and developed using lower exposure doses than is possible with PPMS layers. While lower exposure doses can mean a significant improvement in throughput, this discovery is particularly important when viewed from the standpoint of 193 nm photo lithography processes. Currently available 193 nm stepper machines have sophisticated optics that degrade over time when exposed high doses of the 193 nm deep-UV light. These optics are extremely expensive components of the stepper and can become consumable products when exposed too high of a fluence of 193 nm light. Films deposited according to the methods of the present invention can be patterned using exposure doses of 193 nm deep-UV less than 20 mJ/cm² and developed to form smooth lines at a resolution of 0.1 µm.

The present inventors have found that embodiments of the invention using TMS ((CH₃)₃SiH) are particularly useful in 193 nm photolithography processes. Such PPTMS layers have improved stability over time as compared to PPMS layers and are able to form smoother lines at lower exposure doses than PPMS layers. While PPTMS layers are relatively sensitive to process variations, excellent resolution (0.1 µm) can be obtained when using 193 nm deep-UV photolithography.

The inventors have found that embodiments of the invention using DMS are less sensitive to process variations than TMS embodiments and are particularly useful in both 193 nm and 248 nm photolithography processes. Similar to PPTMS layers, such PPDMS layers have improved stability over time as compared to PPMS layers and are able to form smoother lines at lower exposure doses than PPMS layers. The inventors have found PPDMS films to absorb light closer to the surface and oxidize more completely than PPTMS films, while PPTMS films oxide more deeply, but less completely than PPDMS films.

These and other embodiments of the present invention, as well as its advantages and features, are described in more detail in conjunction with the text below and attached figures.
Figs. 1A-1E are simplified cross sections of a portion of a substrate being processed to form a pattern according one aspect of the present invention;
Fig. 2 is a simplified flow chart summarizing a process for forming a pattern from a polymerized trimethylsilane layer according to one embodiment of the present invention;
Figs. 3A-3F are simplified cross sections of a portion of a substrate being processed to transfer a pattern to an oxide layer using a bi-level resist process according to one embodiment of the present invention;
Fig. 4 is a simplified flow chart summarizing a process for using a bi-level resist with a polymerized trimethylsilane layer in a pattern-transfer process according to one embodiment of the present invention;
Figs. 5A and 5B are simplified representations of one type of deposition system that can be used to form plasma-polymerized organosilane layers according to the present invention;
Fig. 5C is a simplified representation of one type of plasma etch system that can be used to develop plasma-polymerized organosilane layers according to the present invention;
Fig. 6 is a scanning electron micrograph of lines on a substrate formed using methylsilane;
Fig. 7 is a graph comparing the stability in air of a plasma-polymerized methylsilane layer with a plasma-polyermized trimethylsilane layer and a plasma-polymerized dimethylsilane layer formed according to embodiments of the present invention;
Fig. 8 is a graph comparing the contrast versus exposure dose of a plasma-polymerized methylsilane layer with a plasma-polymerized trimethylsilane layer formed according to one embodiment of the present invention;
Fig. 9 is a graph of a Fourier-Transform infra-red analysis of an as-deposited plasma-polymerized trimethylsilane layer;
Fig. 10 is a graph of Fourier Transform infra-red analyses of a plasma-polymerized trimethylsilane layer after various stages of processing;
Fig. 11 is an SEM of developed lines formed from a PPTMS layer;
Fig. 12 is a graph of Fourier Transform infra-red analyses of a plasma-polymerized methysilane, dimethylsilane and trimethylsilane layers;
Fig. 13 is a graph showing the contrast curves for two different PPDMS development processes;
Fig. 14 is an SEM of a bi-level resist pattern formed using PPTMS at a 193 nm exposure with a line width less than the line spacing;
Fig. 15 is an SEM of a bi-level resist formed using PPTMS at a 193 nm exposure with a line width equal to line spacing resist pattern;
Fig. 16 is an SEM of a bi-level resist formed using PPTMS at a 193 nm exposure with a pattern transfer into a polysilicon underlayer; and
Fig. 17 is an SEM of a bi-level resist formed using PPDMS at a 193 nm exposure to form 0.10 µm width lines spaced 0.10 µm apart.

The present invention provides a process for forming a patterned, at least partially inorganic, layer on a semiconductor substrate. The process generally includes depositing a plasma polymerized organosilicon film (a PPOS film) from an organosilane precursor that includes at least one hydrogen atom and at least two carbon atoms attached to a silicon atom, photo-patterning the film to form oxidized regions, and developing the patterned film by selectively etching non-oxidized regions of the photo-patterned film with a plasma. Suitable precursors include dimethylsilane [(CH₃)₂ SiH₂] (DMS), trimethylsilane [(CH₃)₃ SiH] (TMS), diethylsilane [(C₂H₅)₂ SiH₂] and triethylsilane [(C₂H₅)₃ SiH] among others. The developed oxide film can include vias, trenches, and/or other apertures for construction of devices on the substrate or for use as a hard mask for etching one or more sublayers. In a further embodiment, the etch selectivity of an oxidized region formed in a plasma-polymerized film is controlled according to a selected concentration of oxygen in the developing plasma.

Films formed from DMS will be referred to as "PPDMS" films, while films formed from TMS will be referred to as "PPTMS." The deposition process of the present invention can be performed using commercially available substrate processing equipment. For example, the layer can be deposited in a cluster tool such as the PRECISION 5000® or CENTURA® deposition systems manufactured by APPLIED MATERIALS, Inc. of Santa Clara, California when outfitted with a resistively-heated DxZ™ chamber, also available from APPLIED MATERIALS, Inc.. Patterning exposure can be done on an ASML/300 DUV system manufactured by ASM LITHOGRAPHY Holding N.V. of Veldhoven, the Netherlands for exposure at 248 nm, or at 193 nm on an ASML/900 DUV system on an ISI™ Stepper manufactured by INTEGRATED SOLUTIONS, INC., or other suitable exposure system. The patterned layer can be developed in a plasma etching chamber, such as a DPS™ chamber, also manufactured by APPLIED MATERIALS, Inc. The process of the present invention is useful in the patterning of feature sizes in devices manufactured using sub 0.25 um design rules, and embodiments of the present invention can be employed in the printing of feature sizes as small as 0.10 um or less when patterned with a 193 nm DUV tool using resolution enhancement techniques.

The present invention provides improved line roughness, thicker layers of polymerized oxide, superior stability in air, high photosensitivity and allows greater development-etch selectivity. These improved polymerized oxide layers provide superior critical dimension uniformity and control as compared to previously known PPMS photolithography techniques. Additionally, the thicker, smoother-edged polymerized oxide layers serve as superior process masks, such as a single-layer resist mask for a pattern-transfer etch process, or a top-layer mask in a bi-level process.

### I. An Exemplary Single-Layer Dry Photolithographic Process

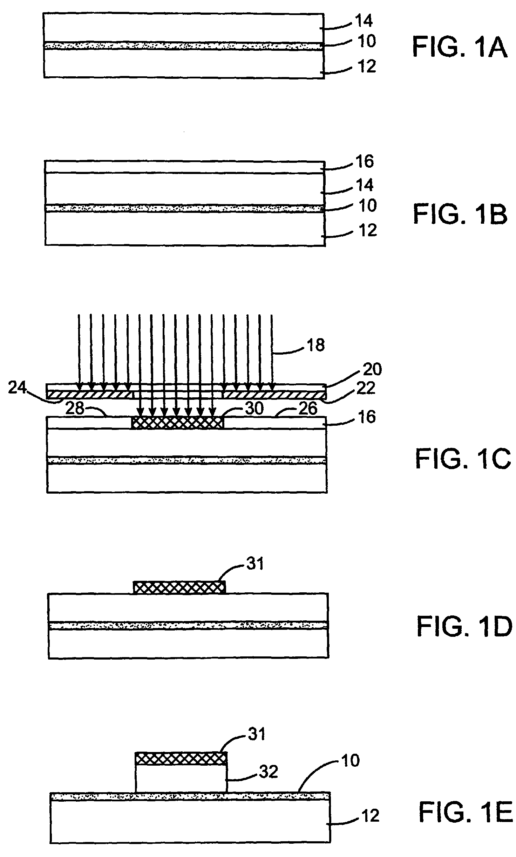

In order to better appreciate the present invention, reference is first made to Figs. 1A through 1E, which are simplified cross-sectional drawings of a portion of a substrate illustrating the sequence used to deposit and pattern a single-layer PPOS, negative tone development application for forming a polysilicon gate according to the present invention. The PPOS layer may be a PPDMS, PPTMS or other plasma-polymerized organosilane layer formed by plasma polymerizing an organosilane precursor having at least two Si-C bonds and at least one Si-H bond. It is understood that the process sequence is only an example and is not intended to be limiting. For example, other materials may underlie the PPOS layer, such as a metal layer for a metal gate or interconnect, an intermetallic material, or a dielectric material, such as a "low-k" (low dielectric constant) material. It is further understood that other devices and device features may be formed.

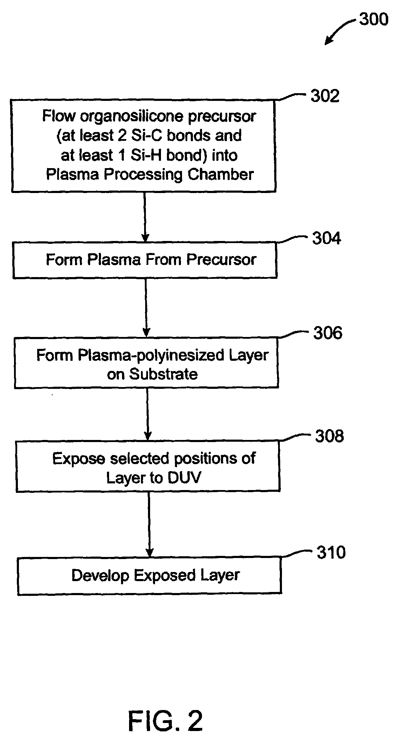

In Fig. 1A, a gate oxide layer 10 has been formed on a silicon substrate 12 and a polysilicon layer 14 has been formed on the gate oxide layer. Fig. 1B shows a layer of PPOS 16 that has been formed on the poly-silicon layer in a plasma-enhanced CVD process. Details of the PPOS deposition process according to the present invention are described in detail in conjunction with Fig. 2 after the description of Figs. 1A-1F.

Fig. 1C illustrates the PPOS layer 16 being exposed to DUV light, represented by arrows 18, through a patterned mask 20 in the presence of an oxidizer, such as air or an oxygen-containing gas mixture. Opaque areas 22, 24 of the mask block the DUV light from selected portions 26, 28 of the PPOS layer, while the exposed portion 30 of the PPOS layer is converted to plasma-polymerized organosilane oxide, which will be referred to as PPOSO. It is understood that PPOSO refers generally to exposure-oxidized PPOS, and is not limited to a particular or specific material structure or stoichiometry, as the degree of oxidation and/or resulting material structure may vary, especially along a cross-section of the layer

Fig. 1D illustrates the development-etch process in which a plasma is used to preferentially etch the un-exposed PPOS, leaving a remaining layer 31 of PPOSO. A chlorine-containing plasma, is selective between the PPOS and PPOSO material, that is, the plasma etches the PPOS material at a different rate, in this instance faster, than the PPOSO material. The difference in etch rates is known as the etch selectivity. Other halogens, such as a fluorine or bromine, may be used in addition to or alternatively to chlorine. In this manner, an exposed PPOS layer may be developed to produce a negative-tone patterned layer.

Generally, the higher the etch selectivity (for the negative-tone, chlorine-containing plasma process), the more PPOSO material will be left when all of the PPOS material has been removed. As will be discussed in further detail below, oxygen may be added to the development-etch plasma to increase the etch selectivity. A "high contrast" mask layer has relatively more of the original thickness of the pre-development etch layer remaining after development. A patterned (exposed and developed) mask layer of sufficient thickness and density can be used as a process mask, in this case as an etch mask to define the polysilicon gate regions.

An optional oxidation process, such as an oxygen-plasma strip process or UV cure, can follow the development etch to convert the rest of the material to SiO₂. As will be discussed in further detail below, the selectivity of the development etch for exposed PPOSO versus unexposed PPOS can be selectively controlled during development. Generally, a higher concentration of oxygen in the development plasma, a higher HBr:Cl₂ ratio, a higher chamber pressure, and a lower RF bias power result in higher selectivity. Normally, a highly selective, highly oxidized PPOSO layer is desired; however, in some circumstances, such as when positive and negative features both are spaced very close together, it may be desirable to limit the selectivity during the etch process because of the oxidation-gradient transition between exposed and unexposed regions that might otherwise limit the ability to clear the unexposed photomask material. Furthermore, oxidation following the develop step can be done using an oxygen-plasma strip process or a UV cure to convert the rest of the material to silicon oxide. The process can be performed, in an ASP™ chamber, which uses a remote microwave plasma generator to avoid ion damage to the substrate, or a DxZ™ chamber, both available from APPLIED MATERIALS, INC., for example, or other chambers used with other systems.

Fig. 1E illustrates using the PPOSO layer 31 as a process mask for etching a polysilicon gate 32. A conventional Cl₂/HBr/O₂-based plasma is used for this process, as is known in the art. The cross sections are not to scale, and the thickness of the layers are shown for illustration purposes only. In this process, the gate dielectric layer 10 was not etched during the pattern-transfer process.

Fig. 2 is a simplified flow chart of a process 300 for forming a patterned PPOS layer. In Fig. 2, an organosilane precursor having at least two Si-C bonds and at least one Si-H bond is provided to a processing chamber containing a substrate upon which integrated circuits are being manufactured (step 302). A plasma is formed from the organosilane precursor (step 304), and a layer of PPOS is formed on the substrate (step 306). Selected portions of the PPOS layer are ten exposed to light (step 308) to at least partially oxidize the layer. The exposed PPOS layer is then developed in a plasma etch process (step 310) to selectively remove portions of the layer.

According to the method of the present invention, the PPOS layer formed in step 306 is formed from a high-carbon organosilane precursor such as dimethylsilane or trimethylsilane. It is believed, however, that other high-carbon organosilane precursors could be used as long at the precursor includes a silicon atom having at least two silicon-carbon bonds and at least one silicon-hydrogen bond. Examples of such other precursors include diethylsilane, triethylsilane, dipropylsilane, tripropylsilane, etc. Generally, liquid sources are less preferred than gaseous sources because of the extra hardware cost associated with vaporizing the liquid sources. Also, longer chain hydrocarbons are generally less preferred than shorter chain hydrocarbons because it can be harder to strike a plasma with the longer chain compounds and harder to form Si-Si bonds in the resulting PPOS layer. Finally, it is important to have at least one Si-H bond to obtain sufficient Si-Si bonding. Too few Si-Si bonds in the resulting film will result in light absorbtion problems and lower oxidation efficiency, which in turn will lead to poor etch selectivity and require high exposure doses. Thus, tetramethylsilane and other sources without Si-H bonds are not desirable precursors for deep-UV photolithography processing according to the present invention.

The present inventors have discovered that depositing the PPOS layer from such a high-carbon organosilane precursor gas results in (1) a more stable (i.e., more resistant to oxidation) layer than a layer formed from methylsilane and (2) a more photosensitive layer. The increased photosensitivity of the PPOS layer is particularly surprising and allows PPOS layers deposited according to the present invention to be successfully patterned and developed using lower exposure doses than is possible with PPMS layers. While lower exposure doses can mean a significant improvement in throughput, this discovery is particularly important when viewed from the standpoint of 193 nm photolithography processes. Currently available 193 nm stepper machines have sophisticated optics that degrade over time when exposed high doses of the 193 nm deep-UV light. These optics are extremely expensive components of the stepper and can become consumable products when exposed too high of a fluence of 193 nm light.

PPDMS films deposited according to the present invention can be successfully patterned and developed using either 193 or 248 nm UV radiation. In certain embodiments of the invention deposited PPDMS films can be developed using 248 nm radiation at an exposure dose less than 50 mJ/cm² and greater than 25 cJ/cm². In other embodiments, the deposited PPDMS films can be developed using 193 nm radiation at an exposure dose between 5-20 mJ/cm². PPTMS films deposited according to specific embodiments of the present invention can be patterned and developed using 193 nm UV radiation at an exposure dose between 5-20 mJ/cm². Higher exposure doses of 193 nm UV radiation could be used to develop either the PPDMS or PPTMS films but such doses would potentially damage the expensive optics components of the 193 nm photolithography tools currently known to the inventors.

The inventors have determined that suitable PPTMS layers can be formed as PPOS layer 16 on an 8-inch silicon wafer in a DxZ chamber running on a Centura 5200 platform. It is to be understood, however, that an 8-inch wafer is used as an example only, 6-inch, 12-inch, or other types of wafers could alternatively be used in chambers sized appropriately. The Centura® platform is equipped with two loadlocks capable of processing 50 wafers and holding the wafers under vacuum until ready for lithography.

For deposition of the PPTMS layer in specific embodiments, the wafer is heated to a temperature of between about 50-150°C and spaced from the gas distribution manifold a distance between about 200-600 mils. TMS is supplied at a flow rate of between about 10-500 sccm and combined with a hydrogen or helium flow of between about 0-1000 sccm, and a plasma formed at an RF power level between about 100-500 Watts (13.56 MHz) and a chamber pressure between about 1.0-5.0 Tort. The resulting PPTMS layers had a refractive index of between about 1.58-1.66.

Argon, nitrogen or another relatively inert gas (i.e., a gas having constituents that do not incorporate into the film in a significant quantity) can be used in place of or in combination with hydrogen and/or helium. Surprisingly, it was found that flowing hydrogen gas into the chamber during the deposition process can actually decrease the amount of hydrogen incorporated into the PPTMS layer in some circumstances. In one embodiment, a combination of nitrogen and hydrogen is preferred as the dilutent gas as such a combinational flow is less expensive than using only hydrogen.

The inventors have determined that PPDMS films can also be deposited using an Applied Materials DxZ dielectric CVD chamber outfitted for 8-inch wafers. In specific embodiments, the PPDMS film is deposited at a pressure between 1.0-2.0 Torr and forming a plasma using between 50-400 Watts of RF power (13.56 MHz). The wafer is heated to a temperature between 60-160°C and spaced from the gas distribution manifold between 275-425 mils. DMS is supplied at a flow rate between 50-250 sccm. Additionally, a diluent gas such as hydrogen, helium, argon, nitrogen or other relatively inert gas can be used during deposition to further fine tune the film properties. One specific process is 1.5 Torr, 150 Watts 13.56 MHz radio frequency power, 325 mil heater to electrode spacing, 120°C, 100 sccm dimethylsilane, and 100 sccm H₂. Using these process conditions, PPDMS films can be deposited over a 200 mm wafer with less than 1.5% (1σ) variation in thickness, and ± 0.01 variation in the refractive index.

For either the PPDMS or PPTMS processes, it is preferred in certain embodiments that the deposition pressure be kept at or above 1.0 Torr to provide a commercially acceptable film deposition rate. It is also preferred in certain embodiments that the chamber be cleaned after each deposition. In one example, the chamber can be cleaned by running a 600 Watt in-situ CF₄/N₂O plasma clean recipe after each deposition. After all the wafers had been processed, the loadlock is then vented to atmosphere using N₂ gas, and the wafers are unloaded into a container and purged with rapidly flowing N₂ gas until ready to use.

### II. An Exemplary Bi-Layer Photolithographic Process

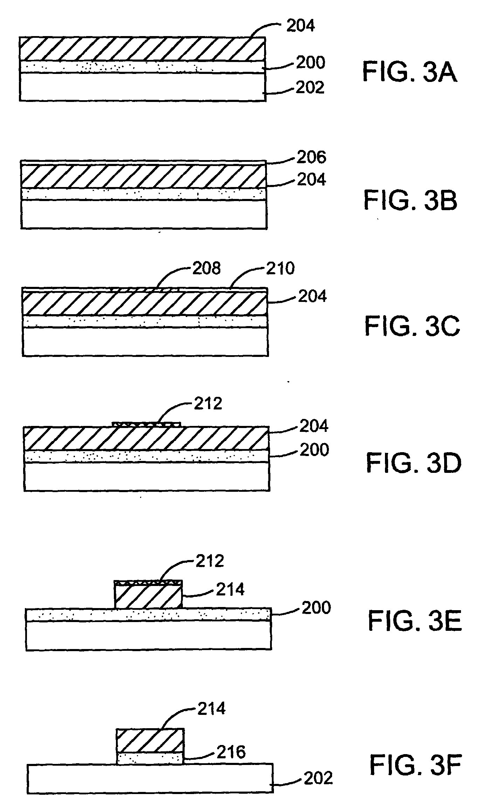

Figs. 3A-3F are simplified cross sections of a portion of a substrate illustrating the steps of a bi-layer resist process using a PPOS precursor. As with Figs. 1A-1E, the PPOS layer may be a PPDMS, PPTMS or other plasma-polymerized organosilane layer formed by plasma polymerizing an organosilane precursor having at least two Si-C bonds and at least one Si-H bond.

In Fig. 3A, an oxide layer 200 is formed on a substrate 202. In the embodiment, the oxide layer is a silicon oxide layer formed by thermal growth or deposition. In other embodiments layer 200 is an oxynitride or other dielectric layer, a metal layer, an intermetallic layer, or a semiconductor layer, such as a polysilicon layer. A layer of photoresist 204 is formed on the dielectric layer 200 by spinning a conventional, organic, liquid photoresist, or other appropriate organic materials, according to conventional technologies. The organic underlayer is hard-baked, as photosensitivity of the organic underlayer is not relied on in this instance, rather the known properties and process compatibility of the hard-baked organic under layer is desired.

In Fig. 2B a layer of PPOS 206 is deposited over the photoresist layer 204 as described above. Fig. 2C shows the PPOS layer after exposure to DUV light with an exposed portion 208, which has at least partially been oxidized to PPOSO, and an unexposed portion 210. Fig. 2D shows the exposed portion of the PPOS layer after a development etch and oxygen plasma strip.

Fig. 2E shows the patterned hard-baked photoresist layer 214 after an anisotropic oxygen plasma etch is used to transfer the pattern of the PPOSO layer 212 to the hard-baked organic underlayer. This pattern transfer etch selectively has selectivity greater than 100:1 organic underlayer to PPOSO. Fig. 2F shows a patterned oxide layer 216 after a second pattern-transfer etch, which in this case is a conventional oxide etch for use with a hard-baked photoresist or other organic underlayer mask. The second pattern-transfer etch selectively etches the layer underlying the hard-baked photoresist more than the hard-baked photoresist. If there is low selectivity between the underlying layer and the PPOSO, the PPOSO will be etched concurrently with the underlying layer. In this instance, Fig. 2E is drawn without a PPOSO layer to show that the PPOSO layer was etched away before the oxide layer was etched to the substrate, but it is understood that whether the PPOSO layer is completely removed or not depends on the selectivity of the second pattern-transfer etch and the relative thickness of the PPOSO and underlying layers, among other factors. The hard-baked organic underlayer can be stripped, if desired, using conventional methods, and further processing may be performed on the substrate.

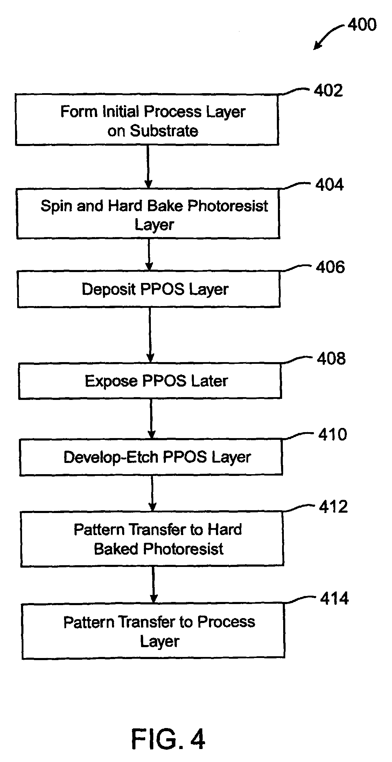

Fig. 4 is a simplified flow chart of a process 400 for a bi-level resist process. A process layer is formed on a substrate (step 402). The process layer could be an oxide layer, a dielectric layer, a metal layer, a semiconductor layer, or other type of layer or combinations of layers and material. Photoresist or other organic material is applied, e.g. spun, sprayed, dipped, onto the process layer and hard-baked (step 404). A layer of PPOS is deposited on the hard-baked photoresist layer (step 406), exposed with DUV light through a photomask (step 408) and developed in a development etch process, as described above (step 410).

A first pattern-transfer etch is used to transfer the pattern of the developed PPTMS layer to the hard-baked photoresist layer (step 412). A second pattern transfer etch is then used to transfer the pattern of the hard-baked photoresist layer to the process layer (step 414). In some instances the first pattern-transfer and the second pattern-transfer etch process may be combined, depending on the particular materials and etch chemistries used. The hard-baked photoresist and any remnant of the developed PPOS layer can then be stripped, if desired, using conventional methods (not shown).

### III. An Exemplary PPOS Deposition System

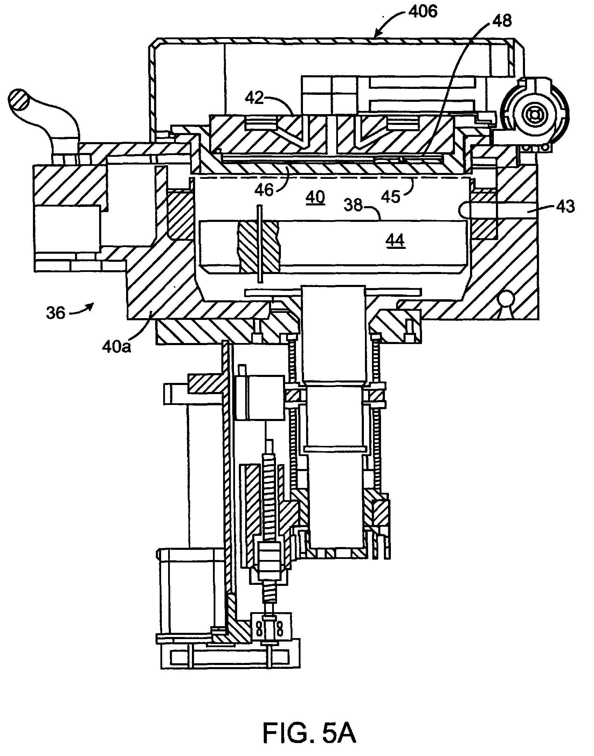

Fig. 5A is a simplified representation of a CVD system 36 suitable for forming plasma-polymerized organosilane ("PPOS") layers on a substrate according to the present invention. The system has a processing chamber 40 that includes a chamber wall 40a and chamber lid assembly 4%. The CVD system contains a gas distribution manifold 42 for dispersing process gases to the substrate, which rests on a surface 38 of a heated pedestal 44 within the process chamber. The pedestal can be moved controllably between a lower loading/off-loading position (as shown), so that a wafer can be loaded or unloaded through port 43, and an upper processing position (indicated by dashed line 45), which is closely adjacent to a gas distribution faceplate 46. A centerboard (not shown) includes sensors for providing information on the position of the wafers.

Deposition and carrier gases are introduced into the chamber through perforated holes of a gas distribution plate, or faceplate, 46. More specifically, deposition process gases flow into the chamber through the inlet manifold 42 (indicated by arrow 47), through a perforated blocker plate 48, and then through holes in the gas distribution faceplate 46.

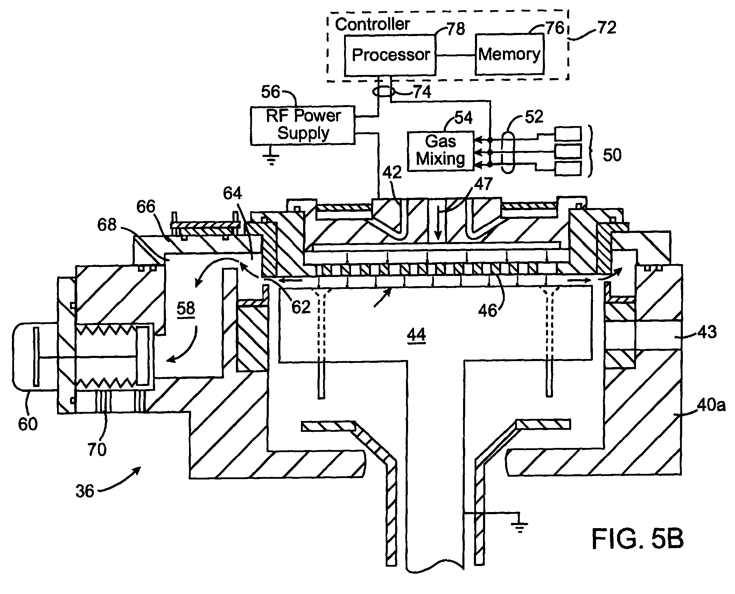

Fig. 5B is a simplified representation of additional features of the CVD system 36. Before reaching the manifold 42, deposition and carrier gases are input from gas sources 50 through gas supply lines 52 into a mixing system 54 where they are combined and then sent to the manifold 42. Generally, the supply line for each process gas includes (i) several safety shut-off valves (not shown) that can be used to automatically or manually shut-off the flow of process gas into the chamber, and (ii) mass flow controllers (also not shown) that measure the flow of gas through the supply line. When toxic gases are used in the process, the several safety shut-off valves are positioned on each gas supply line in conventional configurations.

During a plasma-enhanced deposition process performed within the CVD system, an RF power supply 56 applies electrical power between the gas distribution faceplate 46 and the pedestal 44 so as to excite the process gas mixture to form a plasma within the cylindrical region between the faceplate and the pedestal. (This region will be referred to herein as the "reaction region"). Constituents of the plasma react to deposit a desired film on the surface of the semiconductor wafer supported on the pedestal 44. RF power supply 56 can be operated at a mixed frequency RF power supply to supply power at a high RF frequency (RF1) of 13.56 MHz and at a low RE frequency (RF2) of 360 KHz, or at a single frequency, in this case 13.56 MHz. Pedestal 44, which is resistively heated, can help maintain the wafer at a desired temperature.

During a plasma deposition process, the plasma heats the entire process chamber, including the walls of chamber body 40a surrounding the exhaust passageway 58 and the shut-off valve 60. A liquid can be circulated through passages (not shown) within the walls of the process chamber to maintain the chamber at a desired temperature. Fluids used to control the temperature of the chamber walls include fluids such as water-based ethylene glycol or oil-based thermal transfer fluids. Such temperature control can heat the walls to beneficially reduce or eliminate condensation of undesirable reactant products and improve the elimination of volatile products of the process gases and other contaminants that might contaminate the process if they were to condense on the walls of cool vacuum passages and migrate back into the processing chamber during periods of no gas flow.

The remainder of the gas mixture that is not deposited in a layer, including reaction products, is evacuated from the chamber by a vacuum pump (not shown). Specifically, the gases are exhausted through an annular, slot-shaped orifice 62 surrounding the reaction region and into an annular exhaust plenum 64. The annular slot and the plenum are defined by the gap between the top of the chamber's cylindrical side wall and the bottom of the circular chamber lid 66. The 360° circular symmetry and uniformity of the slot orifice and the plenum are important to achieving a uniform flow of process gases over the wafer so as to deposit a uniform film on the wafer.

From the exhaust plenum 64, the gases flow underneath a lateral extension portion 68 of the exhaust plenum 64, past a viewing port (not shown), past a vacuum shut-off valve 60 (whose body is integrated with the lower chamber wall), and into the exhaust outlet 70 that connects to the external vacuum pump (not shown) through a foreline (also not shown).

Typically, any or all of the chamber lining, gas inlet manifold faceplate, and various other reactor hardware are made out of material such as aluminum, anodized aluminum, or ceramic. An example of such a CVD apparatus is described in U.S. Patent 5,558,717 entitled "CVD Processing Chamber," issued to Zhao *et al.* The 5,558,717 patent is assigned to Applied Materials, Inc., the assignee of the present invention, and is hereby incorporated by reference in its entirety.

Various components of the CVD system 36, such as shut-off valves, flow controllers, throttle valve, RF power supply, and chamber and substrate heating systems are all controlled by a system controller 72 over control lines 74, of which only some are shown. The controller relies on feedback from optical sensors to determine the position of movable mechanical assemblies such as the throttle valve and susceptor which are moved by appropriate motors under the control of controller. In a preferred embodiment, the controller includes a memory 76, such as a hard disk drive, a floppy disk drive, or a ROM card, and a processor 78. The memory can be loaded with a software program to configure the CVD system in a unique manner, or to perform a unique process.

The above reactor description is mainly for illustrative purposes, and other plasma CVD equipment such as electron cyclotron resonance (ECR) plasma CVD devices, induction coupled RE high density plasma CVD devices, or the like may be employed. Additionally, variations of the above-described system, such as variations in pedestal design, heater design, RF power frequencies, location of RF power connections and others are possible. For example, the wafer could be supported by a susceptor and heated by quartz lamps. The layer and method for forming such a layer of the present invention is not limited to any specific apparatus or to any specific plasma excitation method.

### IV. An Exemplary Development Etch System

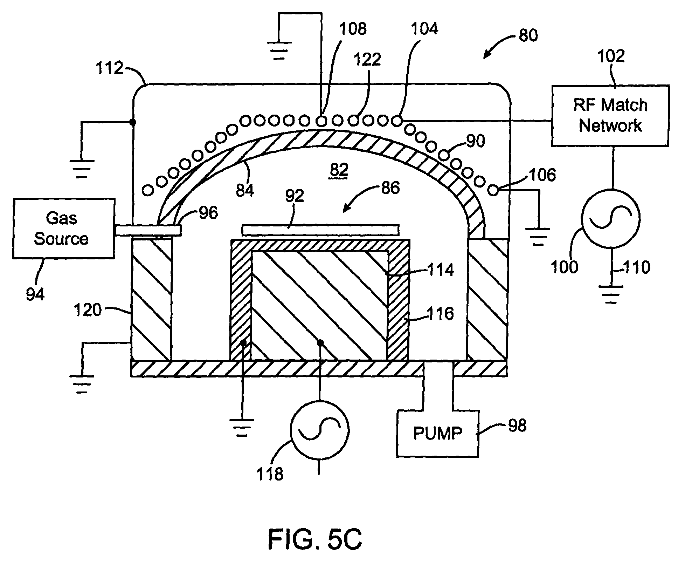

Fig. 5C is simplified representation of an etch system 80 suitable for performing the development etch step in a dry photolithography process, as well as other etch steps, such as a pattern-transfer etch. The system includes a process chamber 82 with an arcuate-shaped, non-conductive or dielectric ceiling 84, which may be a dome, preferably a multiple-radius dome, supported in facing spaced overlapping relationship with the wafer pedestal 86. The central portion of the ceiling is centered relative to a coil 90 , and relative to the wafer pedestal 86, which is configured to support a semiconductor wafer or other substrate 92. A processing gas source 94 provides gas to the chamber through a gas inlet 96. A pump 98 controls the chamber pressure in conjunction with the processing gas source, and can generally evacuate the chamber to a selected pressure. In addition, the pump and gas source may be adjusted to provided a selected gas flow rate through the chamber at a fixed or varied selected chamber pressure.

A plasma source power supply 100 provides RF energy to the coil 90 through an RF matching network 102. RF power is supplied to the coil at a "hot" tap 104, and the coil is grounded through a ground tap, or taps 106, 108, thus completing the circuit with the plasma source power supply, which is grounded 110. The location of the hot tap and the ground tap are given as examples only, and the location or polarity can be varied according to the desired plasma density distribution within the chamber. A ground shield 112 surrounds the coil portion.

The pedestal 86 includes an interior conductive portion 114 that is electrically isolated from both the chamber base 120 of the chamber and an exterior grounded portion 116 of the pedestal. An RF bias supply 118 provides RF energy to the interior conductive portion 114 of the pedestal.

Some of the RF source power provided to the coil 90 couples through the non-conductive chamber ceiling 84 to form a relatively high-density plasma in the vicinity of the coil. The high density plasma results in a relatively high plasma density gradient in the vicinity of the coils; however, the plasma in the vicinity of the substrate 92 is more uniform in density due to ion diffusion and other factors. Furthermore, the generation of the plasma is typically accompanied by heat, high-energy radiation, very reactive plasma species, and other potentially undesirable products that could damage a process wafer. In this chamber, the plasma generation occurs away from the substrate, thus the plasma essentially buffers the wafer from the plasma-generating environment. This sort of plasma is referred to as a decoupled plasma.

The RF bias source 118 creates an alternating electric field essentially orthogonal to the surface of the substrate 92. This field accelerates plasma species, such as ions, to and from the surface of the wafer. These mobile ions can physically sputter or react with the surface of the substrate to result in an anisotropic process. For example, a selective etch species can be biased to etch a trench with a higher aspect ratio than what might be obtained without an RF bias.

Preferably, the coil 90 is wound in a multi-radius shape, but can range between a right cylinder shape and a planar shape, in addition to other configurations. The preferred multi-radius coil is conformal with the multi-radius curvature of the ceiling 84, but the coil can be non-conformal. In a preferred embodiment, the central portion 122 of the coil is most nearly flat and is closest to the center of the ceiling.

As with CVD system 36, various components of etch system 80 (e.g., gas shut-off valves and flow controllers (not shown), pump 98, plasma power supply 100 and RF bias supply 118 among others) are controlled by a system controller (not shown). In some embodiments, system controller 72 can control both CVD system 36 and etch system 80.

A more complete description of an example of a chamber suitable for the development etch and/or pattern-transfer etch is found in U.S. Patent No. 5,753,044, issued May 19, 1998 to Hanawa et al., and assigned at-issue to Applied Materials, Inc., the disclosure of which is incorporated herein for all purposes. Of course, other types of etch systems or processes may be used, such as a capacitively coupled etch system, a remote plasma etch system, with or without a bias, or even a wet etch system.

### V. Experimental Results Comparing PPMS Films to PPTMS and PPDMS Films

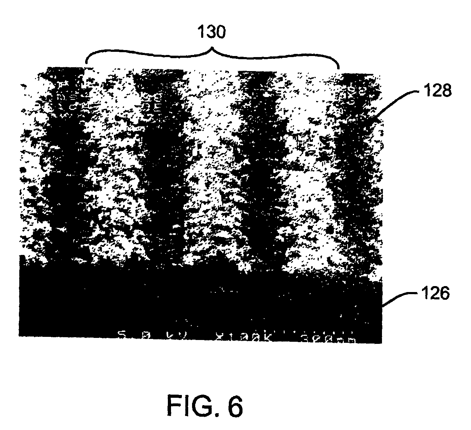

Fig. 6 is a scanning electron micrograph ("SEM") of exposed and developed lines of PPMS 130 on an oxide layer 126 of a substrate. The lines were formed on 0.15 µm line spacings. The PPMS layer was deposited to a thickness of about 2,000 Å in a DxZ chamber, and the development process included a 40% over-etch period, that is, after the PPMS has nominally been removed from unexposed areas during a development etch time, t, then the development etch is continued for an additional "overetch" period of(0.4 * t) to clear the unexposed areas of remnant PPMS. As discussed above, an exposure gradient typically develops between exposed and unexposed areas, and using an overetch technique restores the intended pattern to some extent. However, as seen in the SEM, the thickness of the remaining PPMSO layer appears rather thin. This may be do in part to the overetching, but may also be due in part to the exposure and low-selectivity development characteristics of PPMS/PPMSO. The SEM also shows that the edges 128 of the PPMSO lines 130 is uneven and granular.

The inventors hypothesized that the hydrogen content of the MS during the plasma polymerization deposition process affected the stability of the PPMS film, and that if the hydrogen content could be lowered, a more stable film might result. The first experiments sought to reduce the hydrogen incorporated in the PPMS film by diluting the plasma with hydrogen gas, thus providing more reactive species of hydrogen to combine with hydrogen released by the MS during the polymerization process. A second round of experiments increased the deposition temperature to basically drive off the hydrogen and promote polymerization. Both experimental approaches resulted in the formation of a surface skin on the PPMS layer, but the material would still oxidize in air.

The inventors then tried precursor gases that include more methyl groups than MS, so that the silicon polymers might be terminated with methyl groups instead of hydrogen atoms, and thus be more stable in air, the methyl groups being less likely to react with oxygen in the air than terminal hydrogen. Dimethylsilane and trimethylsilane were chosen as precursors and separate PPDMS and PPTMS layers were deposited and measured for stability.

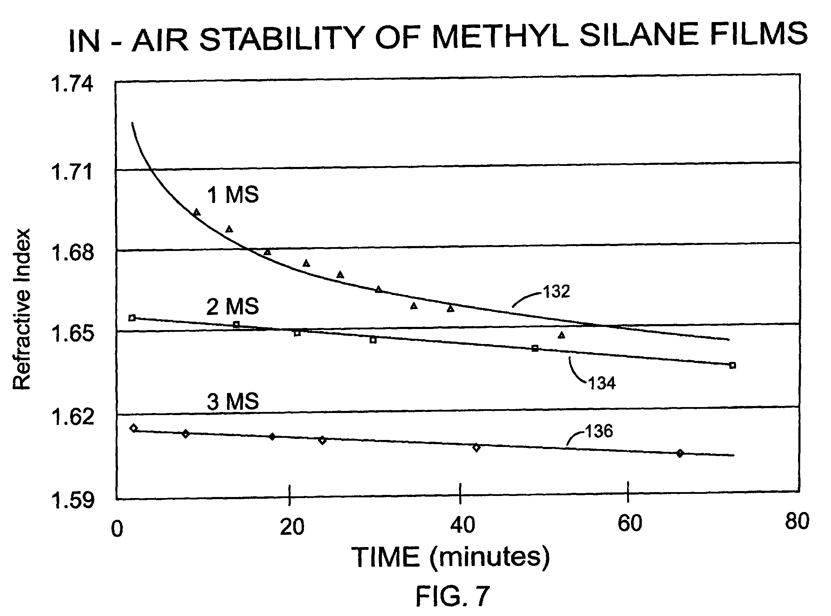

One way to measure stability is to measure the refractive index ("RI") of a polymerized silicon layer over time. The RI of a stable material will remain essentially constant, whereas the RI of an unstable layer will tend to decrease as the layer oxidizes (e.g., is exposed to the ambient). Fig. 7 compares the RI of a PPMS process layer 132 against the RI of a PPDMS process layer 134 and a PPTMS process layer 136.

Layer stability is particularly important in a stepped, or step and scan, exposure process. A stepped exposure process exposes a portion of a wafer at a time, stepping the mask across the wafer until the entire wafer is exposed. An exposure stepped and scanned across an 8-inch wafer may take as long as 1-2 minutes, depending on the die size and the required dose for each die. This is generally not a problem with conventional, spun-on photoresists. However, with PPMS, the exposed PPMSO in prior steps typically continue to oxidize as the subsequent steps are exposed, since the entire wafer is generally exposed to air during the entire stepped exposure process. Thus, the first exposed step will continue to oxidize for up to 15 minutes, or perhaps even longer, before the last step is exposed.

It was determined for an exemplary PPMS layer that this period of air oxidation is equivalent to a change in the exposure dose of about 20 mJ/cm². In other words, if each step is exposed to 60 mJ/cm² of DUV light, by the time the last step is exposed, the first step will have a degree of oxidation equivalent to an exposure of 80 mJ/cm². Concurrently, the unexposed PPMS is oxidizing, typically at a faster rate than the exposed PPMS, reducing the eventual contrast between the exposed and unexposed portions of the PPMS layer. In some embodiments it may be possible to at least partially compensated for by varying the exposure dose across the steps of the wafer. As the final or desired degree of oxidation depends on several factors, including the nominal exposure dose, the degree of polymerization of the PPMS layer, the temperature of the PPMS deposition process, the exposure to the ambient atmosphere, the exposure wavelength, the total stepped exposure time, and the PPMS layer thickness, among others, it will be appreciated that the adjustment of the exposure dose will vary for different applications.

Fig. 7 shows that the RI of the PPDMS layer 134 and PPTMS layer 136 is relatively stable, whereas the RI of the PPMS layer 132 decreases over time when the layers are exposed to air. While not limited by any particular theory, it is believed that the methyl terminations of the PPDMS and PPTMS layers are more resistant to oxidizing in ambient air than hydride terminations of the PPMS layer.

While the present inventors had hypothesized that the PPDMS and PPTMS layers would be more stable than the PPMS layer, they also believed that the PPMS layer would generally require a smaller exposure dose than the PPDMS and PPTMS layers. This belief was due in at least part to having known that hydrogen helps PPOS films become more sensitive to photo oxidation. Thus, it was believed that removing hydrogen from the film, while making it more stable, would also decrease its photo oxidation sensitivity. To the inventors surprise, however, the PPDMS and PPTMS layers exhibited increased photosensitivity rather than decreased photosensitivity and could be developed with higher etch selectivity by the selection of an advantageous etch process.

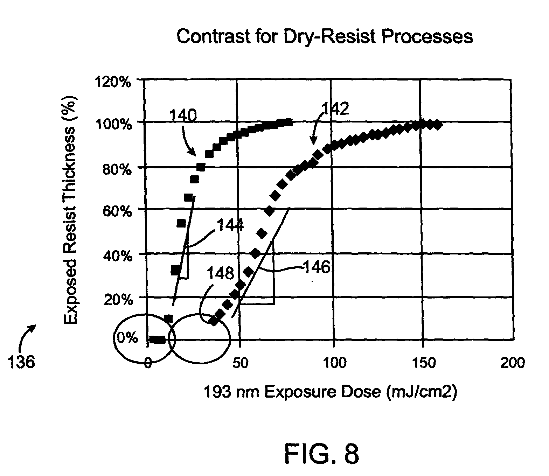

Fig. 8 illustrates that the PPTMS layer is not only more stable in air, but also more photosensitive at a particular exposure wavelength (193 mm in Fig. 8) than the PPMS layer. While one might think that a more stable, i.e., less prone to oxidation, layer would be less likely to oxidize during the exposure process, Fig. 8 shows that this is not the case for a film formed from TMS. Fig. 8 shows the exposed resist thickness 136 (% of as-deposited thickness converted by the exposure) versus exposure dose at 193 nm 138 for a series of exposures of a film formed from TMS 140 and for a series of exposures of a film formed from MS 142. Both films were deposited to an initial thickness of approximately 2,000 Å. The steep slope 144 of the PPTMS curve indicates that a film made from TMS precursor is more sensitive to the exposure dose, resulting in higher contrast, than does the shallow slope 146 of the PPMS curve.

Another feature of the PPTMS film illustrated in Fig. 8 is that the exposure dose required for a given degree of exposed resist thickness is significantly less in the PPTMS film. For example, to achieve approximately 40% exposed resist thickness in a PPTMS film, only about 20 mJ/cm² is required. In comparison, it takes about 64 mJ/cm² of exposure dose to result in the same exposed resist thickness. Being able to lower the required exposure dose is desirable because as previously explained the DUV sources, particularly the lenses, fail sooner when used at higher energy levels. A lower exposure time also reduces process time, which is particularly important for the stepped exposures often used on larger wafers, such as 8-inch or 12-inch wafers.

Thus, not only is a PPTMS film more stable and more photosensitive, but the PPTMS film also reduces process time and improves the lifetime (in wafers before failure) of the exposure equipment. While not restricting the results to any particular theory, it is believed that incorporating additional carbon into the PPOS layer increases the permeability of the layer to oxygen. This effect may counterbalance or outweigh the sensitivity reducing effect of lowering the hydrogen content and result in a film that is actually more sensitive to photo oxidation.

### VI. Results of Fourier-Transform Infrared Analyses

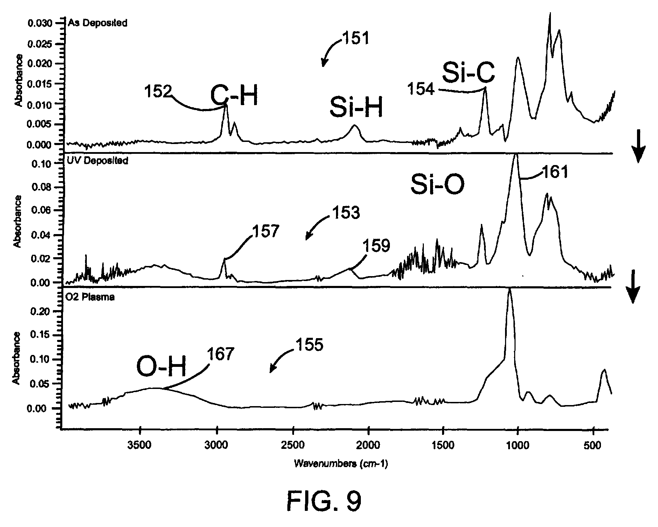

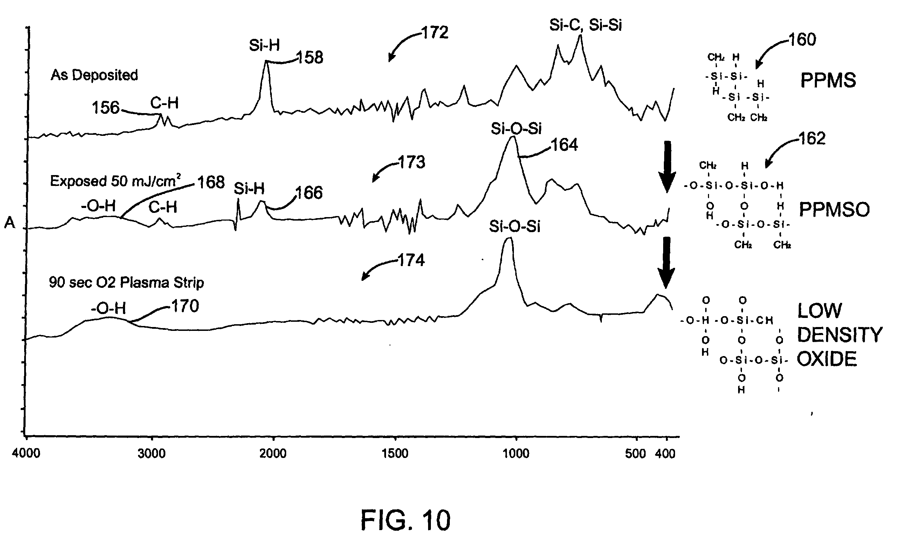

The relative increase in methyl groups in a layer formed from TMS, compared to a layer formed from MS, is illustrated in Figs. 9 and 10. Figs. 9 and 10 are graphs of Fourier-Transform Infra-Red ("FTIR") analyses performed on a layer deposited from TMS and a layer deposited from MS after various processing steps. The x-axes of the graphs are wavenumbers, and relate generally to the bond strength of different chemical bonds present in the material being analyzed, and the y-axis is relative amplitude, the higher the peak indicating a greater presence of a particular type of bond.

Fig. 9 shows three curves 151, 153, and 155. The first curve 151 represents an as-deposited PPTMS layer and shows a fairly high carbon-hydrogen peak 152, indicating the presence of methyl groups, and a fairly high silicon-carbon peak 154, which is consistent with a large number of methyl groups in the layer. The second curve 153 represents the PPTMS layer after DUV exposure. The carbon-hydrogen peak 157 and silicon-hydrogen peak 159 have diminished somewhat in comparison to the as-deposited curve 151. In addition, the silicon-oxygen peak 161 has increased in amplitude. The third curve 155 represents the PPTMSO film after an oxygen plasma strip process in an ASP chamber. It is believed that some of the terminations are hydroxyl groups, as evidenced by the O-H peak 167. The lack of a prominent C-H peak suggests that most of the methyl terminations have been eliminated. While this specific example was generated from TMS precursor, it is believed that other precursors could be used to form a stable, photosensitive film, and that such a film might show selective contrast depending on the development etch conditions.

Fig. 10 shows three curves 172, 173, and 174 that represent a layer formed from MS after processing similar to that represented in Fig. 9. The first curve 172, illustrates an as-deposited film, which has a fairly low carbon-hydrogen peak 156, indicating a low concentration of methyl groups in the film (compare to 152, Fig. 9), while the silicon-hydrogen peak 158 is fairly high. The next curve 173 shows the same film after an exposure of 50 mJ/cm² at 248 nm in air. A peak representing silicon-oxygen-silicon bonds 164 has grown, and the silicon-hydrogen peak 166 has diminished, as oxygen or hydroxyl groups, represented by a broad peak 168, have replaced terminal hydrogen atoms. The third curve 174 shows the layer after a 90 second oxygen plasma strip process.

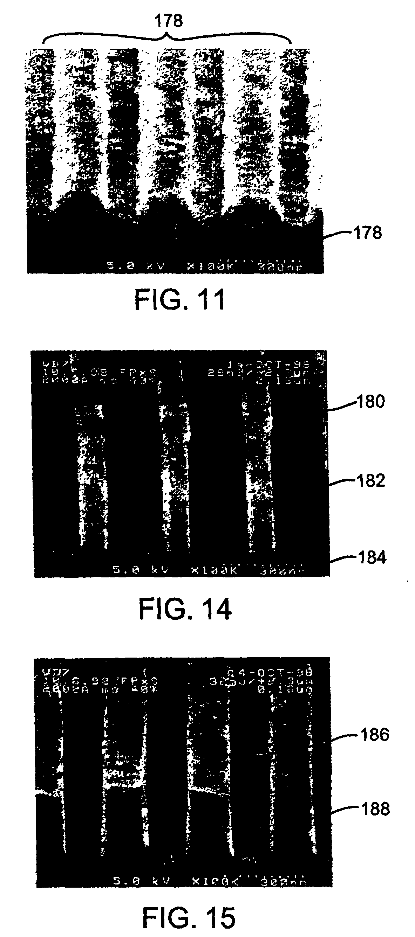

Fig. 11 is an SEM of exposed and developed lines of PPTMS 176 on an oxide layer 178 of a substrate. The lines were formed on 0.16 µm line spacings, which is essentially the same for purposes of comparison as the PPMSO lines shown in Fig. 6. The PPTMS layer was deposited to a thickness of about 2,000 Å in a DxZ™ chamber, and then developed with a 40% over-etch period in a DPS™ chamber. Two surprising characteristics are noticeable when comparing Figs. 11 and 6. The first is the granularity of the developed PPMS lines compared to the smooth edges of the developed PPTMS lines. The second is the thickness of the PPTMS lines compared to the thickness (height) of the developed PPMS lines.

While not restricting the results to any particular theory, it is believed that the PPMS results in a more granular developed layer because MS is more likely to polymerize into longer Si-Si chains, which then oxidize as a cluster. It is believed TMS, in comparison, forms shorter chains of silicon-silicon bonds and remains more amorphous during development and oxidation. Since a substantial amount of silicon-silicon polymerization is desired to result in the contrast between the exposed and unexposed areas of the polymerized silane layer, it is surprising that better photolithographic results may be obtained with DMS and TMS because it is less likely to polymerize into long Si-Si chains. The greater remaining thickness of the PPTMS lines are believed to be due to higher contrast.

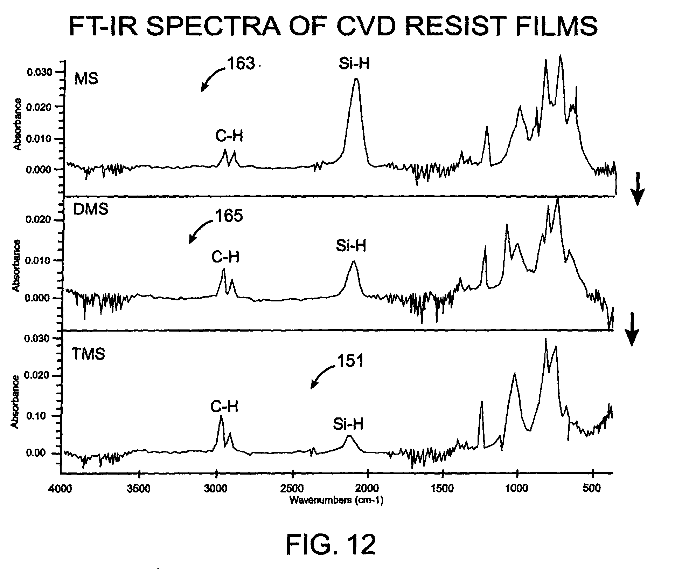

Fig. 12 shows the same FTIR curve 151 as shown in Fig. 9 and also shows FTIR curves for as-deposited PPMS (163) and PPDMS (165) layer. As evident in Fig. 12, PPDMS layer 165 and PPTMS layer 151 include a higher carbon content and lower hydrogen content than PPMS layer 163.

### VII. Development Processes For Polymerized Methyl-Silanes

In addition to the deposition and exposure steps, the development etch process can also be optimized for dry photolithographic processes. In particular, it was determined that the development etch selectivity between exposed and unexposed portions of a polymerized silane layer formed from TMS can be varied between about 1:1 and about 1:1000 by controlling the amount of oxygen present in the development etch plasma. It is understood that other parameters, such as chamber pressure, plasma source power, plasma bias power, and the concentration of various other species in the plasma will also effect selectivity. However, selectivity is sensitive to the total flow of oxygen gas (O₂) or other oxygen-source gas, such as ozone, water vapor, or oxygen diluted with an inert gas like He, or Ar, into the plasma etch chamber. In the case of oxygen gas, it was found that a selectivity of 1:1 could be obtained with no oxygen in the development etch plasma under certain etch conditions.

It was found that development etch gases flown into the chamber containing about 0-200 sccm HBr, about 0-200 sccm Cl₂, and about 2-20% O₂ were particularly desirable. In one embodiment, the etch gas flow rate included 150 sccm HBr, 30 sccm Cl₂, and 8 sccm O₂, which produced a contrast of about 100. The chamber pressure is preferably between about 4-15 mTorr, the RF source power is between about 100-1,000 Watts for an 8-inch wafer, the RF bias power is between about 5-100 Watts, and the wafer is heated to a temperature between about 5-50 C in a DPS™ chamber. This etch plasma that not only developed a negative tone print in the polymerized TMS layer, but also efficiently etched an underlying polysilicon layer, as illustrated in the sequence of Figs. 1A-1E.

In another embodiment, a mixture of Cl₂ and O₂ is used to etch the exposed PPTMS layer. The O₂ content may vary between about 0-50% of the total flow rate. A flow of about 20% O₂ is expected to produce a contrast of about 1:100. As discussed above, an oxygen-source plasma precursor other than diatomic oxygen gas, such as ozone or water vapor, may be used to increase the oxygen concentration of the development plasma, similarly, other halogen sources, such as HCl or F₂ could be used in other etch processes.

The inventors discovered that PPDMS films offer a wider range of development conditions than PPMS and/or PPTMS films. This can provide a significant advantage for integrated circuit manufacturers as several different development conditions can be varied and optimized to optimize etch uniformity and ensure or obtain appropriate critical dimension uniformity.

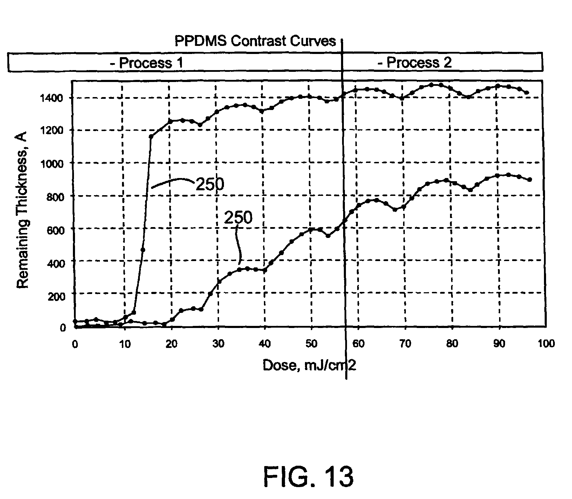

Fig. 13 shows the amount of film remaining after a development process (initial deposit 1500 Å) as a function of the 248 nm exposure dose (unexposed film at zero dose) for two different PPDMS development processes. The successful development of a patterned PPDMS film depends on the ability of the etch process to create such a contrast (remaining film thickness difference) between exposed and unexposed areas of the film. In Fig. 13, curve 250 represents a development process designed to provide high contrast at a low exposure dose. Line 252, on the other hand, is the process that has much less contrast.

For development processes paralleling conditions used for polysilicon etching, the trend generally observed was that contrast was improved by increasing the pressure, increasing the HBr to Cl₂ ratio and by decreasing the bias power applied to the wafer chuck. Selectivity was also found to be highly sensitive to the flow of oxygen. Small increases in oxygen flow markedly increased of unexposed to exposed material, but beyond a certain threshold increasing oxygen flow reduced the etch rate of both films to unacceptably low levels and actually reduced selectivity.

The inventors have discovered the patterned PPDMS film development can be achieved in a relatively wide range of process conditions. The etch process can create contrast between exposed and unexposed areas of the film using a variety of plasma chemistries: a) chlorine only, b) chlorine and oxygen, c) chlorine and hydrogen bromide (the currently preferred process), d) chlorine, hydrogen bromide and oxygen, and e) any of the above chemistries with helium or argon dilution. In the DPS chamber, the ranges of the corresponding gas flows are: 1-200 sccm chlorine, 1-400 sccm hydrogen bromide, 1-50 sccm oxygen, 1-200 sccm helium, 1-400 sccm argon. The other etch process conditions may also vary in a relatively wide range: 1-100 mTorr, 100-2000 Watt inductively coupled power, 1-200 Watt bias power, 10-70°C cathode temperature.

It is significant that the PPDMS film development does not require the use of a low selectivity (breakthrough) step to remove spontaneously oxidized material from the surface. The latter is due to the increased (PPDMS) film stability relative to the plasma polymerized methylsilane (PPMS) film. Furthermore, the developed PPDMS film exhibits a decrease in line edge roughness relative to a baseline process employing PPMS, with a decrease in exposure dose.

### VIII. Trimethylsilane Polymer Bi-Level Pattern Transfer Layers

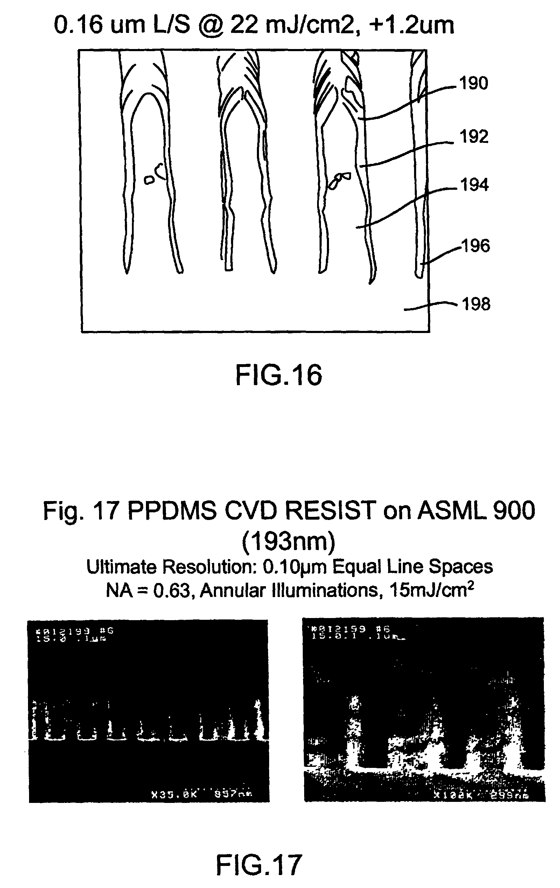

Fig. 14 is a SEM that illustrates the use of a developed PPTMS layer in a bi-level pattern-transfer process. A layer of PPTMSO 180 has been developed on a layer of organic material 182. In this instance, the organic material is hard-baked photoresist approximately 5,000 Å thick, but could be other organic material, such as polyamide, polyacrylic ether ("PAE"), FLARE, or SLIK or other low-dielectric constant material. The PPTMSO was developed in a chlorine-bromine-oxygen-containing plasma, which was then used to etch the organic layer down to the substrate 184. The pattern is a 0.10 µm line spacing at a .320 µm pitch. The exposure of the PPTMS layer is approximately 28 mJ/cm2 at 193 nm. An isolated line made by the same process sequence had a 3-sigma line edge roughness ("LER") of about 6 nm.

Fig. 15 is an SEM of a layer of PPTMSO 186 on a layer of hard-baked photoresist 188 with 0.16 µm line spacing at 0.32 µm pitch. In this instance the PPOS layer was exposed at a dose of 32 mJ/cm2. The closely spaced lines had a 3-sigma LER of 6 nm. Transferring a pattern from the PPTMS layer to an organic layer, particularly a layer of photoresist, allows DUV exposure techniques to be used to result in a wafer with a patterned, standard, photoresist layer. Many subsequent fabrication processes have been developed using photoresist layers patterned at higher exposure wavelengths, and thus it is desirable in some instances to form such a patterned layer, even though other processes may be developed to work with a layer of patterned PPTMSO.

Fig. 16 is an SEM of a layer of patterned PPTMSO on a layer of hard-baked photoresist 192. In accordance with methods described above, the PPTMSO was exposed and developed, and the pattern was transferred to the photoresist. Subsequently, the pattern of the PPTMSO and photoresist was transferred to the a polysilicon layer 194 using a conventional dry etch process. The polysilicon etch process stopped at an oxide layer 196, which in a fabrication process could be a gate dielectric layer. The oxide layer was formed on a substrate 198, which in this instance is a silicon wafer.

Fig. 17 is an SEM of 193 nm patterned PPDMS bi-level resist showing 0.10 µm width lines spaced 0.10 µm apart. In this instance the PPDMS was exposed at a dose of 15 mJ/cm².

As shown in Fig. 17, PPDMS films deposited according to the method of the present invention can be successfully used to form feature having a resolution of 0.10 µm.

While the above provides a description of alternative and preferred embodiments of the invention, those skilled in the art understand that various modifications may be made without departing from the invention. For example, although examples have been presented for two common DUV wavelengths, other wavelengths may be used. Similarly, PPOS layers may find applications on substrates other than silicon semiconductor wafers. As such, the above description is illustrative and not restrictive. The parameters listed in the above processes should not be limiting to the claims herein, as in many cases the chosen parameters depend on the desired result, and process parameters may be interrelated in some instances. The scope of the invention should therefore be determined with reference to the appended claims, along with their full scope of equivalents.

## Claims

1. A process for forming a patterned resist layer on a substrate, the process comprising:
a) flowing an organosilane precursor having a silicon atom bound to at least two carbon atoms and to at least one hydrogen atom into a processing chamber containing the substrate;
b) forming a plasma from the organosilane precursor to form a layer of plasma-polymerized organosilane on the substrate;
c) exposing, in an oxidizing ambient, selected portions of the layer of plasma-polymerized organosilane to a dose of radiation less than 50 mJ/cm² to at least partially oxidize the selected portions of the layer to form exposed portions of the layer and non-exposed portions of the layer; and
d) developing the layer using an etch process to selectively remove the exposed portions or the non-exposed portions.

2. The process of claim 1 wherein the oxidizing ambient is air.

3. The process of claim 1 wherein the radiation has a wavelength less than or equal to about 248 nm.

4. The process of claim 1 wherein the etch process is a plasma etch process.

5. The process of claim 4 wherein the plasma etch process uses a plasma comprising oxygen and a halogen.

6. The process of claim 5 wherein the halogen is chlorine.

7. The process of claim 4 wherein the plasma etch process is a decoupled plasma process.

8. The process of claim 1 wherein said organosilane precursor is trimethylsilane.

9. The process of claim 8 wherein said radiation has a wavelength of about 193 nm and said plasma-polymerized organosilane layer is exposed to a dose of said 193 nm radiation of about 20 mJ/cm² or less.

10. The process of claim 1 wherein said organosilane precursor is dimethylsilane.

11. The process of claim 10 wherein said radiation has a wavelength of about 193 nm and said plasma-polymerized organosilane layer is exposed to a dose of said 193 nm radiation of about 20 mJ/cm² or less.

12. The process of claim 10 wherein said radiation has a wavelength of about 248 nm and said plasma-polymerized organosilane layer is exposed to a dose of said 248 nm radiation greater than about 20 mJ/cm².

13. The process of claim 8 wherein said trimethylsilane precursor is flowed into the processing chamber at a rate between about 10-500 sccm, the plasma is formed at a power of between about 2-10 Watts/in² and during formation of the plasma, the pressure of the processing chamber is maintained between about 1.0-5.0 Torr and the substrate is maintained at a temperature between about 50-150 C.

14. The process of claim 1 wherein said chamber is maintained at a pressure between 1.0 and 5.0 Torr during deposition of said resist layer.

15. The process of claim 1 wherein, during formation of said plasma, hydrogen is flowed into said chamber in addition to said organosilane precursor.

16. A method for forming a patterned resist layer on a substrate, the process comprising:
a) flowing an organosilane precursor having a silicon atom bound to at least two carbon atoms and to at least one hydrogen atom into a processing chamber containing the substrate;
b) forming a plasma from the organosilane precursor to form a layer of plasma-polymerized organosilane on the substrate;
c) exposing, in an oxidizing ambient, selected portions of the layer of plasma-polymerized organosilane to a dose of radiation having a wavelength of about 193 nm or less to at least partially oxidize the selected portions of the layer to form exposed portions of the layer and non-exposed portions of the layer, said dose of radiation being less than or equal to about 20 mJ/cm²; and
d) developing the layer using an etch process to selectively remove the exposed portions or the non-exposed portions.

17. The method of claim 16 wherein said organosilane precursor is dimethylsilane.

18. The method of claim 16 wherein said organosilane precursor is trimethylsilane.

19. The method of claim 16 wherein said dose of radiation is greater than or equal to about 5 mJ/cm².

20. The method of claim 19 wherein said radiation has a wavelength of about 193 nm.

21. The method of claim 16 wherein hydrogen is flowed into said chamber during formation of the plasma-polymerized organosilane layer.

22. A process for forming a patterned resist layer on a substrate, the process comprising:
a) flowing trimethylsilane into a first processing chamber containing the substrate;
b) forming a plasma from the trimethylsilane to form a layer of plasma-polymerized trimethylsilane on the substrate;
c) removing the substrate from the first processing chamber;
d) exposing, in an oxidizing ambient, selected portions of said plasma-polymerized trimethylsilane layer to radiation having a wave length less than or equal to about 248 nm;
e) placing the substrate in a second processing chamber;
f) forming a plasma in the second processing chamber to etch the non-exposed portions of the layer leaving at least some of the exposed portions of the layer on the substrate.

23. The method of claim 22 wherein the plasma in said second chamber includes chlorine and oxygen species.

24. A method for selecting the contrast between an exposed portion and an unexposed portion of a plasma-polymerized organosilane layer on a substrate comprising:
a) placing the substrate in a plasma processing chamber;
b) flowing a chlorine-containing plasma precursor into the chamber at a first selected rate;
c) flowing an oxygen-containing plasma precursor into the chamber at a second selected rate, the second selected rate being chosen according to a desired contrast between the exposed portions and the unexposed portions of the plasma-polymerized organosilane layer;
d) forming a plasma from the chlorine-containing precursor and the oxygen-containing precursor; and
e) etching the plasma-polymerized organosilane layer with the plasma.

25. The method of claim 24 wherein the plasma-polymerized organosilane layer is a plasma-polymerized trimethylsilane layer.

26. The method of claim 24 wherein the second selected rate is between about 0-50% of a total flow rate into the chamber.

27. The method of claim 24 further comprising a flow of hydrogen bromide wherein the second selected rate is between about 0-12 sccm, the first selected rate is between about 0-200 sccm, and the flow of hydrogen bromide is between about 0-200 sccm.

28. The method of claim 24 wherein the desired contrast is between about 1:1 and about 1:100.

29. The method of claim 24 wherein the step (e) of etching is performed at a pressure between about 2 mTorr-70 mTorr.

30. The method of claim 24 wherein the plasma processing chamber has a source RF power supply and a bias power supply, and the step (e) of etching is performed at a source RF power of between about 2-20 Watts/in² and a bias RF power of between about 0.1-2 Watts/in².

31. A method for selecting the contrast between an exposed portion and an unexposed portion of a plasma-polymerized organosilane layer on a substrate comprising:
a) placing the substrate in a plasma processing chamber;
b) flowing a chlorine gas into the chamber at a first selected rate between about 1-200 sccm;
c) flowing an oxygen gas into the chamber at a second selected rate between about 1-12 sccm, the second selected rate being chosen according to a desired contrast between the exposed portions and the unexposed portions of the plasma-polymerized organosilane layer;
d) flowing hydrogen bromide into the chamber at a third selected rate between about 0-200 sccm;
e) heating the substrate to between about 5-50 C;
f) forming a plasma in the chamber at a chamber pressure of between about 2-70 mTorr with an RF source power of between about 2-20 Watts/in² and an RF bias power of between about 0.1-2 Watts/in²; and
g) etching the plasma-polymerized organosilane layer with the plasma.

32. A method of exposing a plasma-polymerized organosilane layer on a substrate, the method comprising:
a) exposing a first portion of the plasma-polymerized organosilane layer to deep ultra-violet radiation at a first selected dose through a photomask in an oxygen-containing ambient;
b) stepping the photomask to a second portion of the plasma-polymerized organosilane layer; and
c) exposing the second portion to deep ultra-violet radiation at a second selected dose, the second dose being selected according to the stability of the plasma-polymerized organosilane layer in the oxygen-containing ambient.
